Europäisches Patentamt

(19) European Patent Office

Office européen des brevets

(11) Publication number: **0 216 525 B1**

# EUROPEAN PATENT SPECIFICATION

(45) Date of publication of patent specification: **06.11.91**   (51) Int. Cl.⁵: **F04D 29/28, H05K 7/20**

(21) Application number: **86306601.5**

(22) Date of filing: **27.08.86**

(54) **A rotatable centrifugal fan blade assembly and air flow circulation apparatus.**

(30) Priority: **06.09.85 US 773280**

(43) Date of publication of application:
**01.04.87 Bulletin 87/14**

(45) Publication of the grant of the patent:
**06.11.91 Bulletin 91/45**

(84) Designated Contracting States:
**DE FR GB**

(56) References cited:
**GB-A- 2 142 786**
**US-A- 2 870 959**
**US-A- 4 092 687**
**US-A- 4 385 333**

(73) Proprietor: **SEAGATE TECHNOLOGY INTERNA-TIONAL**
**c/o Maples & Calder, P.O. Box 309**
**Georgetown, Grand Cayman Island(KY)**

(72) Inventor: **Pottebaum, Kenneth Lee**
**321 Redbud**
**Yukon Oklahoma 73099(US)**

(74) Representative: **Miller, Joseph et al**
**J. MILLER & CO. Lincoln House 296-302 High Holborn**
**London WC1V 7JH(GB)**

## Description

This invention relates to rotatable centrifugal fan blade assemblies.

US-A-4,385,333 discloses a rotatable centrifugal fan blade assembly comprising a substantially parallel circular rotor and disk member with a centrally disposed aperture and blade members disposed in a plane substantially normal to the plane of the rotor and the disk member.

The movement of air into and out of housings of various units of equipment in use in the work place is done by the means of fans for the most part. As more and more machines are moved into the work place, the level of noise created by them increases substantially. Nevertheless, machines that are used in the modern office, including computer disk drives, must maintain adequate air flow for various purposes, in particular but not limited to maintenance of air pressure differentials and air flows. Accordingly the present invention seeks to provide rotatable centrifugal fan blade assemblies which are relatively quiet and produce an adequate air flow.

According to one aspect of the present invention, there is provided a rotatable centrifugal fan blade assembly comprising: substantially parallel circular rotor and disk members at least one of which has a centrally disposed aperture (19), and a plurality of blade members each disposed in a plane substantially normal to the planes of said rotor and disk members, each blade member having leading and trailing edges, characterised in that at least one of the disk members has cut-outs each of which is located between the connection between two adjacent blade members in said at least one disk, and each of which is defined by a larger area disposed towards the trailing edge of one of said two blade members and by a smaller area disposed toward the leading edge of the other of said two blade members and in that the blade members extend between the rotor and the disk member.

According to a further aspect of the present invention there is provided an air flow circulation apparatus comprising a centrifugal fan blade assembly in which only one of said disk members has a centrally disposed aperture and the second of said disk members comprises a rotor, the apparatus including a spindle member.

In the preferred embodiment the air flow apparatus includes a magnetic media disk mounted on said spindle.

The air flow apparatus may include an electrically conductive element between said rotor and said housing.

The invention is illustrated, merely by way of example, in the accompanying drawings, in which:-

Figure 1 shows a rotatable centrifugal fan blade assembly according to the present invention with one disk or plate removed and viewed from the side of the removed disk;

Figure 2 is a side view of the fan blade assembly of Figure 1;

Figure 3 is a cut-away portion of a disk of a fan blade assembly according to the present invention for the purposes of illustration;

Figure 4 is a top view of an air flow circulation apparatus according to the present invention; and

Figure 5 is a view of the apparatus of Figure 4 taken on the line 5-5.

The present invention will be described in relation to a rotatable centrifugal fan blade assembly specifically adapted for use in a magnetic disk media information storage unit. The particular fan blade assembly described is drawn to dimensions which fit within a space already existing in such a unit.

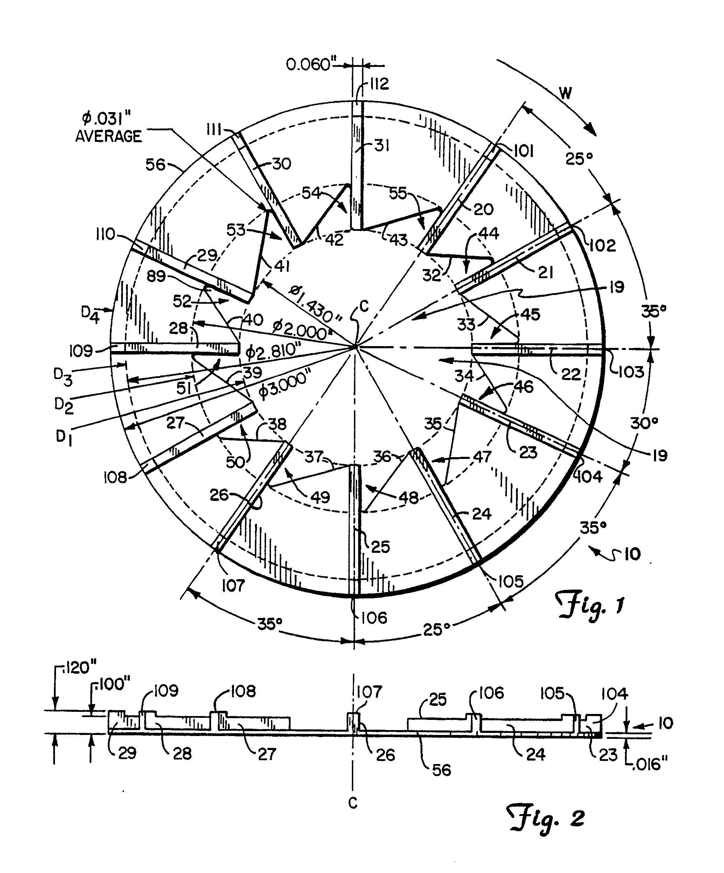

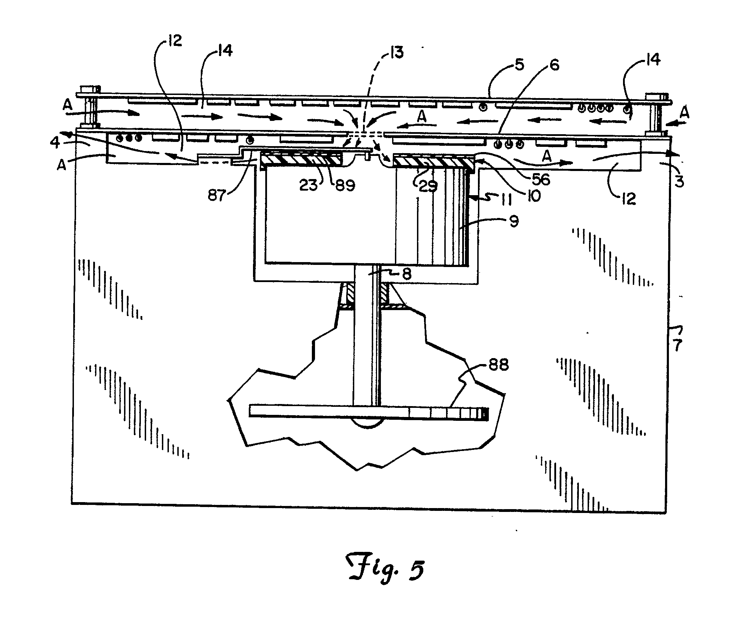

Referring now to Figure 1 there is shown a rotatable centrifugal fan blade assembly 10 according to the present invention viewed from the side to which a rotor 9 (Figure 5) would be attached. The fan blade assembly 10 consists essentially of a flat disk 56 and fan blades 20-31. The blades 20-31 are orientated along radii extending from a line C, normal to the plane of the disk 56, at the centre of the disk. The number and spacing of the blades may be varied and the blades themselves may be curved forwardly or backwardly.

Although it is well known in the art, it is relevant to note that the spacing between one blade and the next, for example the blade 20 to the blade 21 and the blade 21 to the blade 22, varies. This disposition of the blades at varying angular distances from one another is well known to break up the frequency content of the noise generated by the fan blade assembly. So long as the angles distribute the blade/disk weight evenly about the centre of the fan blade assembly, no imbalance will result from such blade distribution.

Figure 2 is a side view of the fan blades 23-29 as they are firmly mounted on (or integrally formed with) the disk 56. Because of the size limitation of the storage unit for which the fan blade assembly of Figure 1 is developed, the outer diameter of the disk 56 is 7.5cm (3 inch) and the height of each of the blades 20-31 is 2.5mm (0.1 inch) through most of the body of the blade and 3mm (0.12 inch) at an outer edge 101-112 of the blades 20-31 respectively. The enhanced size of the outer edges 101-112 permits easy mounting and centring of the blades and the disk onto the rotor 9. It will be appreciated that the disk 56 and the blades 20-31 may be formed as an integral unit.

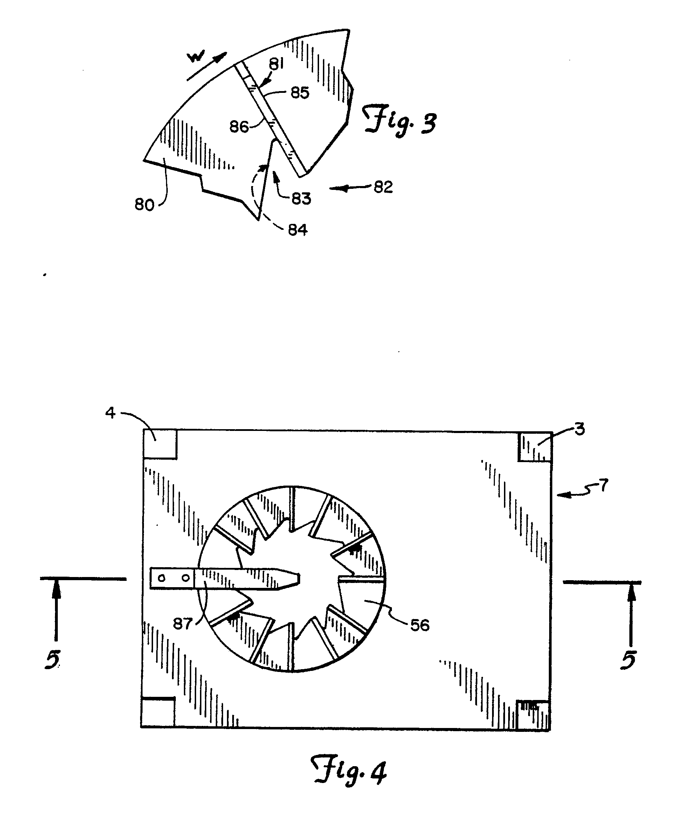

Referring back to Figure 1, the disk 56 is provided with two (concentric and centrally disposed with respect to an external circumference D4) internal circumferences D1 and D2. In Figure 1, the first internal circumference D1 (the most centrally disposed) provides for the narrowest points of inlet aperture 19 through the disk 56. The second internal circumference D2 (disposed distally from the circumference D1) provides for the widest portion of the inlet aperture. If the fan blade assembly is turning in the direction shown by arrow W, that is clockwise, as seen in Figure 1, then the air pressure caused by the rotation of the blades will be greater on the leading edges of the blades than on the trailing edges. This can be seen easily with reference to Figure 3 where the cut-away portion of a disk 80 would be rotating in the direction of the arrow W. A moving blade 81 will develop greater air pressure on a face side or leading edge 85 than on a rear side or trailing edge 86. A disk inlet aperture 82 is expanded by a cut-out 83 defined by a line 84 as if cut from the disk 80. The cut-out 83, therefore, allows air on the opposite side of the disk 80 from the blade 81 to enter at areas where the air pressure is lower, i.e. behind the blade 81. It is believed that the extension of the disk 80 in front of the blade 81 does not allow air to flow back in the wrong direction (opposite to that of entry) to areas where the air pressure is higher, i.e. in front of the blade 81. This special inlet geometry thus effectively increases the inlet size without reducing the effective blade size by allowing the blade to extend to the internal diameter D1 as illustrated in Figure 1, while at the same time allowing for air to enter the fan blade assembly from as wide an area as defined by the circumference D2.

Referring back to Figure 1, it will be noted that one cut-out 44-55 is provided for each of the blades 21-20 respectively. These cut-outs are defined on one side by lines 32-43, respectively, and at their distal end by the circumference D2. For example, the blade 29 has its cut-out 52 defined by a line 40 extending from the circumference D1 to a point 89. The exact path of the line 40 and its corresponding lines 32-39, 41-43 for the other blades extends straight from the circumference D1 at the leading edge of one blade to a point on the circumference D2 less than 3.2mm (0.13 inch) from the trailing edge of the next forward blade, and from that point over an arc or flat to that trailing edge. The trailing edge of each blade provides the forward edge of the cut-out, and the central area of the cut-out is open to a completely removed central portion of the disk 56 defined at its distal perimeter by the circumference D1. These cut-out areas and central circular cut-out defined by the circumference D1 form the inlet aperture 19. For support of the fan blade assembly, some structure (not shown) may be attached to or formed integrally with the disk 56 which may block portions of the inlet aperture to allow the attachment of a spindle or shaft (not shown), upon which the fan blade assembly may rotate.

It will be appreciated that the cut-outs in the fan blade assembly provide a wider inlet space at the area of low pressure behind the blades and that this wider space tapers to a narrower space when it reaches an area in front of the blades. The exact geometry of the cut-out is not critical but it is important that whatever the geometry is, it provides for a wider inlet at the area of lower pressure and a narrower inlet at the face of the blade, an area of higher pressure. It will be seen from Figure 1 that because of the irregular spacing of the blades 20-31, the slopes of the lines 32-43 are drawn to match (or fit) this irregular pattern or spacing. The larger width portion of the cut-outs may be terminated distally at some point further than the circumference D2 so long as the structural integrity of the overall fan blade assembly is not impaired. Likewise, the larger width portion may be terminated distally within the circumference D2. The specific ratios of circumferences shown may be used to scale up or down the size of a fan blade assembly within the preferred embodiment and the ratios themselves may be altered as well, so long as there is a larger opening on the low pressure side of the blades as described above.

Referring now to Figures 4 and 5, the fan blade assembly 10 is seen attached to the rotor 9 to form an air flow circulation apparatus 11 according to the present invention with a media platter 88 connected thereto via a spindle 8. The rotor 9 is connected to a motor (not shown) for rotating the platter 88 which may, for example, be a magnetic media disk. In this side view a point 89 coincident with the circumference D2 of Figure 2 is visible. Above the disk 56 is a conductive element 87 which is electrically connected to the centre of the rotor 9 to prevent electrical build-up on the platter 88. The conductive element 87 is electrically connected to a drive enclosure housing 7 by means of screws Z and R. In operation, air flow is indicated on Figure 4 by arrows A. The primary air flow is directed through an interstice 14 which is a space between circuit boards 5,6, and directed through an aperture 13 in the circuit board 6. The aperture 13 is of an appropriate diameter to ensure that the primary air flow proceeds in the direction just indicated, approximately 1.3cm (0.5 inch) for a 7.5cm (3 inch) blade. Air is then directed outwardly by the blades 20-31 through the interstice 14 to an area outside the housing 7. Clearance between the circuit board 6 and the conductive element 87 is approximately 1.4mm (0.055 inch) and the interstice 14 gives a clearance of approximately 4.8mm (0.19 inch) between the circuit board 5 and the back of the circuit board 6. These dimensions may, of course, be varied.

In known fan blade assemblies, blades were merely built onto the upper surface of a rotor with no covering such as the disk 56. The addition of the disk 56 in the fan blade assembly 10 to quieten the blades decreases their effective width by the width of the disk 56 (that is, otherwise the blades would extend to a width equal to the width shown plus the width of the disk 56). Nevertheless, the design of the fan blade assembly of Figure 1 produces approximately 85 percent of the air flow which is produced by known open bladed assemblies at substantially reduced sound level. The fan blade assembly rotates at approximately 3600 revolutions per minute as conventional. In one known fan blade assembly the fan blades are equally spaced, but 14 blades were required to deliver adequate air flow. The fan blade assembly of Figure 1 produces approximately 85 percent of the air flow of the known fan blade assembly with only 12 blades and eliminates a substantial portion of the noise.

## Claims

1. A rotatable centrifugal fan blade assembly comprising: substantially parallel circular rotor and disk members (9, 56) at least one of which has a centrally disposed aperture (19), and a plurality of blade members (20 - 31) each disposed in a plane substantially normal to the planes of said rotor and disk members (9, 56), each blade member having leading and trailing edges, characterised in that at least one of the disk members has cut-outs (44 - 55) each of which is located between the connection between two adjacent blade members in said at least one disk, and each of which is defined by a larger area disposed towards the trailing edge of one of said two blade members and by a smaller area disposed toward the leading edge of the other of said two blade members and in that the blade members (20, 31) extend between the rotor (9) and the disk member (56).

2. A rotatable centrifugal fan blade assembly as claimed in claim 1, characterised by including a spindle member, the rotor having a surface which is perpendicular to a long axis of the spindle member, said surface having a centrally located substantially cone-shaped mass, the substantially flattened apex of which is directed into said centrally disposed aperture.

3. An air flow circulation apparatus comprising: a centrifugal fan blade assembly as claimed in claim 1 characterised in that only one of said disk members (56) has a centrally disposed aperture (19) and the second of said disk members comprises a rotor (9); and further characterised by including a spindle member (8) rotatable by said rotor and extending therefrom in a direction away from said disk member; a housing (7); and at least first and second circuit board member (5, 6) mounted on said housing, the first board member being mounted relatively near to said disk member and provided with an aperture to allow air flow to pass from a side opposite said disk member to a side facing said disk member, said second board member being positioned so that an interstice (14) exists between said first and second circuit board members of sufficient size to permit air flow therebetween.

4. An air flow apparatus as claimed in claim 2 characterised by including a magnetic media disk (88) mounted on said spindle member.

5. An air flow apparatus as claimed in claim 2 or 3 characterised by including an electrically conductive element (87) between said rotor (9) and said housing (7).

6. An air flow apparatus as claimed in any of claims 3 to 5 characterised in that the rotor has a surface which is perpendicular to a long axis of the spindle member, said surface having a centrally located substantially cone-shaped mass, the substantially flattened apex of which is directed into said centrally disposed aperture.

## Revendications

1. Assemblage de pales de ventilateur centrifuge rotatif, comprenant : un rotor et des organes de disque circulaires (9, 56), sensiblement parallèles, dont au moins l'un présente une ouverture centrale (19), et une pluralité de pales (20 à 31), chacune disposée dans un plan sensiblement normal au plan desdits rotor et organes de disque (9, 56), chaque pale présentant des bords d'attaque et de fuite, caractérisé en ce qu'au moins l'un des organes de disque présente des découpures (44 à 55), dont chacune est située entre la liaison entre deux pales adjacentes, dans ledit au moins un disque, et chacune d'elles est définie par une grande aire disposée en direction du bord de fuite de l'une desdites deux pales, et une petite aire, disposée en direction du bord d'attaque de l'autre desdites deux pales, et en ce que les pales (20, 31) s'étendent entre le rotor (9) et l'organe de disque (56).

2. Assemblage de pale de ventilateur centrifuge rotatif selon la revendication 1, caractérisé en ce qu'il comprend une broche, le rotor présentant une surface perpendiculaire à l'axe longitudinal de la broche, ladite surface présentant une masse centrale, sensiblement conique, dont le sommet sensiblement aplati est dirigé dans ladite ouverture centrale.

3. Dispositif de circulation d'un courant d'air, comprenant : un assemblage de pales de ventilateur centrifuge selon la revendication 1, caractérisé en ce que seul l'un desdits organes de disque (56) présente une ouverture centrale (19) et le second desdits organes de disques comprend un rotor (9) ; et caractérisé en outre par le fait de comprendre une broche (8) susceptible de tourner grâce audit rotor et s'étendant depuis ce dernier, en une direction s'éloignant dudit organe de disque ; un carter (7) ; et au moins un premier et un second organes de panneau de circuit (5, 6) montés sur ledit carter, le premier organe de panneau étant monté relativement près dudit organe de disque et pourvu d'une ouverture pour permettre à l'écoulement d'air de passer d'un côté opposé audit organe de disque vers un côté faisant face audit organe de disque, ledit second organe de panneau étant positionné de façon qu'existe, entre lesdits premier et second organes de panneau de circuit, un interstice (14) de taille suffisante pour permettre à un écoulement d'air de passer entre les organes de panneau.

4. Dispositif de circulation d'air selon la revendication 2, caractérisé en ce qu'il comprend un disque à milieu magnétique (88) monté sur ladite broche.

5. Dispositif de circulation d'air selon la revendication 2 ou 3, caractérisé en ce qu'il comprend un élément conducteur de l'électricité (87) entre ledit rotor (9) et ledit carter (7).

6. Dispositif de circulation d'air selon la revendication 2, caractérisé en ce que le rotor présente une surface perpendiculaire à l'axe longitudinal de la broche, ladite surface présentant une masse en forme de cône, placée sensiblement au centre, dont le sommet sensiblement aplati est dirigé dans ladite ouverture centrale.

**Patentansprüche**

1. In Drehung versetzbarer Schaufelsatz für ein Zentrifugalgebläse mit im wesentlichen parallelen kreisförmigen Rotor- und Scheibenteilen (9, 56), von denen zumindestens eines eine in der Mitte angeordnete Öffnung (19) aufweist, und einer Vielzahl von Schaufelteilen (20-31), die jeweils in einer Ebene im wesentlichen senkrecht zu den Ebenen der Rotor- und Scheibenteile (9, 56) angeordnet sind, wobei jedes Schaufelteil voreilende und nacheilende Kanten aufweist,
dadruch **gekennzeichnet,** daß zumindestens eines der Scheibenteile Ausschnitte (44-55) aufweist, die jeweils zwischen der Verbindung zwischen zwei benachbarten Schaufelteilen in der zumindestens einen Scheibe gelegen sind und die jeweils durch einen größeren Bereich, der in Richtung auf die nacheilende Kante einer der beiden Schaufelteile angeordnet sind, und einen kleineren Bereich gebildet sind, der in Richtung auf die voreilende Kante des anderen der beiden Schaufelteile angeordnet ist, und daß sich die Schaufelteile (20, 31) zwischen dem Rotor (9) und dem Scheibenteil (56) erstrecken.

2. In Drehung versetzbarer Schaufelsatz für ein Zentrifugalgebläse nach Anspruch 1,
dadurch **gekennzeichnet,** daß der Schaufelsatz ein Spindelteil einschließt, daß der Rotor eine Oberfläche aufweist, die senkrecht zu einer langen Achse des Spindelteils verläuft, daß die Oberfläche eine in der Mitte angeordnete im wesentlichen kegelförmige Masse aufweist, deren im wesentlichen abgeflachter Scheitelpunkt in die in der Mitte angeordnete Öffnung gerichtet ist.

3. Luftströmungs-Zirkulationsvorrichtung mit einem Zentrifugalgebläse-Schaufelsatznach Anspruch 1,
dadurch **gekennzeichnet,** daß lediglich eines der Scheibenteile (56) eine in der Mitte angeordnete Öffnung (19) aufweist und daß das zweite der Scheibenteile einen Rotor (9) umfaßt, und weiterhin gekennzeichnet durch den Einschluß eines Spindelteils (8), das von dem Rotor in Drehung versetzbar ist und sich von diesem in einer Richtung von dem Scheibenteil fort erstreckt, eines Gehäuse (7) und zumindestens erster und zweiter Schaltungsplattenteile (5, 6), die auf dem Gehäuse befestigt sind, wobei das erste Schaltungsplattenteil relativ nahe an dem Scheibenteil befestigt und mit einer Öffnung versehen ist, um den Durchgang einer Luftströmung von der dem Scheibenteil gegenüberliegenden Seite zu einer Seite zu ermöglichen, die auf das Scheibenteil gerichtet ist, und wobei das zweite Schaltungsplattenteil derart angeordnet ist, daß ein Zwischenraum (14) zwischen den ersten und zweiten Schaltungsplattenteilen mit einer ausreichenden Größe vorhanden ist, um eine Luftströmung durch diesen Schaltungsplattenteilen hindurch zu ermöglichen.

4. Luftströmungsvorrichtung nach Anspruch 2, dadurch **gekennzeichnet,** daß sie eine Magnetmediumplatte (88) einschließt, die auf dem Spindelteil befestigt ist.

5. Luftströmungsvorrichtung nach Anspruch 2 oder 3, dadurch **gekennzeichnet,** daß sie ein elektrisch leitendes Element (87) zwischen dem Rotor (9) und dem Gehäuse (7) einschließt.

6. Luftströmungsvorrichtung nach einem der Ansprüche 3 - 5, dadurch **gekennzeichnet,** daß der Rotor eine Oberfläche aufweist, die senkrecht zur langen Achse des Spindelteils verläft, daß die Oberfläche eine in der Mitte angeordnete im wesentlichen kegelförmige Masse aufweist, deren im wessentlichen abgeflachter Scheitelpunkt in die in der Mitte angeordnete Öffnung gerichtet ist.

Fig. 1

Fig. 2

7

*Fig. 3*

*Fig. 4*

EP 0 216 525 B1

Fig. 5